(19) Europäisches Patentamt
European Patent Office
Office européen des brevets

(11) Veröffentlichungsnummer: **0 294 773**
**A2**

(12) **EUROPÄISCHE PATENTANMELDUNG**

(21) Anmeldenummer: **88109091.4**

(22) Anmeldetag: **08.06.88**

(51) Int. Cl.[4]: **C08L 71/00 , C08G 65/40 , C08L 81/06**

(30) Priorität: **12.06.87 DE 3719632**

(43) Veröffentlichungstag der Anmeldung:
**14.12.88 Patentblatt 88/50**

(84) Benannte Vertragsstaaten:
**BE DE FR GB NL**

(71) Anmelder: **BASF Aktiengesellschaft**
**Carl-Bosch-Strasse 38**
**D-6700 Ludwigshafen(DE)**

(72) Erfinder: **Heinz, Gerhard, Dr.**
**Im Vogelsang 2**
**D-6719 Weisenheim(DE)**
Erfinder: **Simon, Georg Nikolaus, Dr.**
**Untere Hart 10**
**D-6703 Limburgerhof(DE)**
Erfinder: **Blinne, Gerd, Dr.**
**Im Woogtal 7**
**D-6719 Bobenheim(DE)**

(54) **Polymermischungen auf der Basis von Polyarylethersulfonen.**

(57) Mischungen aus Polyarylethersulfonen A) mit mindestens je 25 mol.% Einheiten, die sich von Bisphenol A und Bisphenol S ableiten, mit Polyarylethersulfonen, die sich zu mehr als 80 mol.% von Bisphenol A bzw. Bisphenol S als Dihydroxyverbindungen ableiten, zeigen ein ausgewogenes Eigenschaftsspektrum.

EP 0 294 773 A2

Xerox Copy Centre

## Polymermischungen auf der Basis von Polyarylethersulfonen

Die Erfindung betrifft Polymermischungen auf der Basis von Polyarylethersulfonen, enthaltend als wesentliche Komponenten

A) 5 - 95 Gew.% eines Polyarylethersulfons, erhältlich durch Polykondensation einer Mischung aus

$a_1$) 10 bis 90 mol.%, bezogen auf die Summe von A)-C),

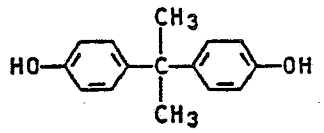

$a_2$) 10 bis 90 mol.%, bezogen auf die Summe von A)-C),

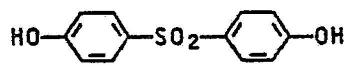

$a_3$) 0 bis 50 mol.%, bezogen auf die Summe von A)-C),

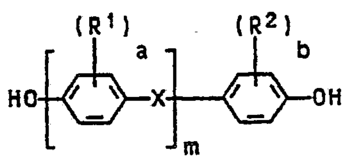

wobei X eine chemische Bindung oder einen Substituenten

$-S-$ , $-O-$ , 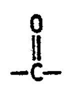 , 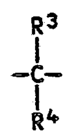 ($R^3=R^4=CH_3$ nur wenn mindestens a oder b $\neq$ 0)

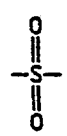 (nur wenn a oder b $\neq$ 0)

$R^1$ und $R^2$ Alkylgruppen mit 1 bis 6 C-Atomen oder $C_1$-$C_6$-Alkoxygruppen, $R^3$ und $R^4$ Wasserstoff, Alkylgruppen mit 1 bis 6 C-Atomen, Arylgruppen oder halogensubstituierte Alkylgruppen mit 1 bis 4 C-Atomen darstellen und m den Wert 0 oder 1 und n und p den Wert 0, 1, 2, 3 oder 4 haben,
mit

$a_4$) 1 bis 100 mo.%, bezogen auf die Summe von D) und E)

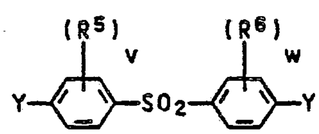

wobei $R^5$ und $R^6$ Wasserstoff sind oder die gleiche Bedeutung wie $R^1$ und $R^2$ haben, Y Cl oder F ist und v und w jeweils den Wert 0, 1, 2, 3 oder 4 haben, und

$a_5$) 0 bis 99 mol.%, bezogen auf die Summe von D) und E)

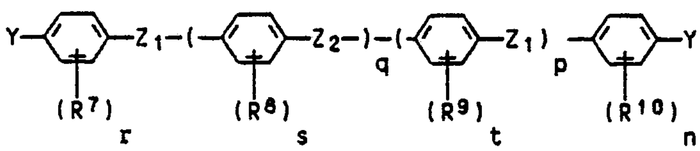

wobei
Y: Cl oder F

$Z_1$: 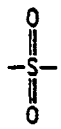 oder 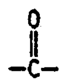

$Z_2$: –O–, –S–, 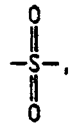, 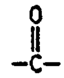 oder eine chemische Bindung darstellen

$R^7$, $R^8$, $R^9$ und $R^{10}$, Wasserstoff, Cl oder F sind oder die gleiche Bedeutung wie $R^1$ und $R^2$ haben können,
q und p den Wert 0 oder 1 haben und
r, s, t und u eine ganze Zahl von 0 bis 4 sein können,
B) 0 - 95 Gew.% eines Polyarylethersulfons mit wiederkehrenden Einheiten der allgemeinen Formel

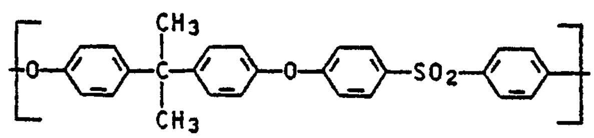

und/oder
C) 0 - 95 Gew.% eines Polyarylethersulfons mit wiederkehrenden Einheiten der allgemeinen Formel

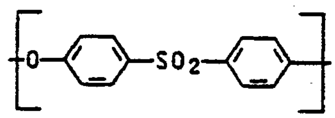

wobei der Gesamtanteil der Komponenten B + C) mindestens 5 Gew.%, bezogen auf A + B + C) beträgt.

Außerdem betrifft die Erfindung die Verwendung derartiger Polymermischungen zur Herstellung von Leiterplatten und elektrischen Steckverbindungen und aus der erfindungsgemäßen Polymermischung als wesentliche Komponenten erhältliche Formkörper.

Polyarylethersulfone mit der allgemeinen Struktureinheit

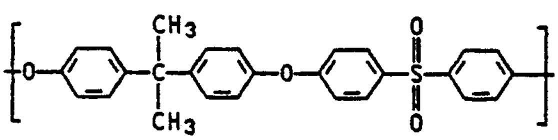

(häufig, wie auch im folgenden, einfach als Polysulfone bezeichnet) zeichnen sich durch eine sehr geringe Wasseraufnahme und damit eine sehr gute Formstabilität (der daraus hergestellten Formteile) aus. Die Wärmeformbeständigkeit, (die häufig durch die maximale Dauergebrauchstemperatur beschrieben wird) ist

jedoch für einige Anwendungszwecke, insbesondere im Falle von aus diesen Massen hergestellten Leiterplatten (printed circuit boards, auch PCB genannt) nicht ausreichend.

Polyarylethersulfone mit der allgemeinen Struktureinheit

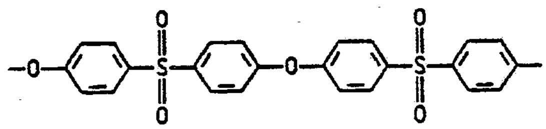

weisen im Vergleich zu Polysulfonen eine bessere Wärmeformbeständigkeit auf, doch ist die Wasseraufnahme wesentlich höher. Dies hat zur Folge, daß Formteile aus Polyarylethersulfonen der letzten Struktur zur Quellung und zum Verzug neigen, was bei der Verwendung in der Elektrotechnik und Elektronik (Herstellung von Leiterplatten für gedruckte Schaltungen) unerwünscht ist.

Mischungen aus Polysulfonen und Polyethersulfonen zeigen einen linearen Zusammenhang zwischen Mischungsverhältnis und Wasseraufnahme, jedoch wird die Wärmeformbeständigkeit durch den Polysulfon-Anteil negativ beeinflußt. Zudem sind Formteile aus derartigen Mischungen infolge der Unverträglichkeit der beiden Komponenten in der Regel nicht mehr transparent, was ebenfalls einen Nachteil darstellt.

In der US-A 4 175 175 und der EP-A 113 112 sowie der EP-A 135 130 werden Copolykondensate beschrieben, die durch Kondensation von Mischungen aus 2,2-Di-(4-hydroxyphenyl)propan (Bisphenol A) und 4,4′-Dihydroxydiphenylsulfon (Bisphenol S) mit 4,4′-Dichlordiphenylsulfon (DCDPS) erhältlich sind.

Diese Copolykondensate weisen zwar gegenüber den Polysulfonen bzw, Polyethersulfonen insgesamt verbesserte Eigenschaften auf, doch sind die Wärmeformbeständigkeit und die Spannungsrißbeständigkeit noch verbesserungsbedürftig. Zur Herstellung von Leiterplatten für gedruckte Schaltungen eignen sich diese Copolykondensate nur sehr bedingt.

Der Erfindung lag daher die Aufgabe zugrunde, Polymermischungen auf der Basis von Polyarylethersulfonen mit einem ausgewogenen Eigenschaftsspektrum, d.h. einer ausreichenden Wärmeformbeständigkeit bei geringer Wasseraufnahme und hoher Spannungsrißbeständigkeit sowie gutem Brandverhalten und geringer Rauchgasentwicklung im Brandfall zur Verfügung zu stellen, die auch zur Herstellung von Leiterplatten, insbesondere Leiterplatten für gedruckte Schaltungen (printed circuit board), geeignet sind.

Diese Aufgabe wird erfindungsgemäß durch die eingangs definierten Polymermischungen auf der Basis von Polyarylethersulfonen gelöst.

Bevorzugte Polymermischungen dieser Art sind den Unteransprüchen und der nachfolgenden detaillierten Beschreibung zu entnehmen.

Die erfindungsgemäßen Polymermischungen enthalten als Komponente A 5 - 95 Gew.% eines Polyarylethersulfons, erhältlich durch Polykondensation einer Mischung von aromatischen Dihydroxyverbindungen $a_1$, $a_2$ und gegebenenfalls $a_3$, mit aromatischen Dihalogenverbindungen $a_4$ und gegebenenfalls $a_5$.

Bei der Dihydroxyverbindung $a_1$ handelt es sich um das als Bisphenol A bekannte 2,2-Di-(4-hydroxyphenyl)propan und bei der Dihydroxyverbindung $a_2$ um 4,4′-Dihydroxydiphenylsulfon, auch als Bisphenol S bezeichnet.

Die Dihydroxyverbindungen $a_3$ haben die allgemeine Formel

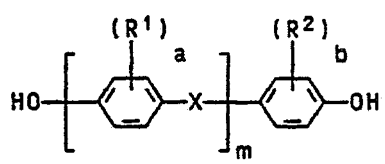

wobei X eine chemische Bindung oder einen Substituenten des Typs

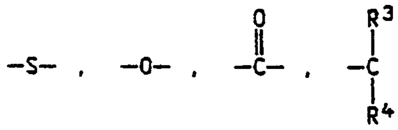 ($R^3=R^4=CH_3$ nur wenn mindestens a oder b $\neq$ 0)

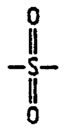 (wenn a oder b $\neq$ 0),

$R^1$ und $R^2$ Alkylgruppen mit 1 bis 6 C-Atomen oder Alkoxygruppen mit 1 bis 6 C-Atomen,
$R^3$ und $R^4$ Wasserstoff, Alkylgruppen oder Alkoxygruppen mit 1 bis 6 C-Atomen, Arylgruppen oder halogensubstituierte Alkylgruppen mit 1 bis 4 C-Atomen darstellen,
m den Wert 0 oder 1, vorzugsweise 1, und
n und p den Wert 0, 1, 2, 3 oder 4 haben.

Vorzugsweise sind $R^1$ und $R^2$ eine Alkylgruppe mit 1 bis 4 C-Atomen, z.B. Methyl-, Ethyl-, i- oder n-Propyl oder n-, i- oder t-Butyl oder entsprechende Alkoxygruppen. Besonders bevorzugt sind Methyl und Ethyl.

Bevorzugte Substituenten $R^3$ und $R^4$ sind $C_1$-$C_4$-Alkylgruppen, wie für $R^1$ und $R^2$ beschrieben, sowie Arylgruppen oder halogensubstituierte Alkylgruppen wie $CF_3$ und $CCl_3$, um nur zwei Beispiele zu nennen.

m steht für die Zahl 0 oder 1 und ist bevorzugt 1, insbesondere dann, wenn p gleich 0 ist, d.h. keine Substituenten $R^2$ vorhanden sind.

n und p können jeweils 0, 1, 2, 3 oder 4 sein, vorzugsweise 0, 1, 2 oder 3.

Nachfolgend werden einige Beispiele für bevorzugte Dihydroxyverbindungen aufgeführt:

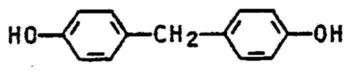
Di-(4-hydroxyphenyl)methan

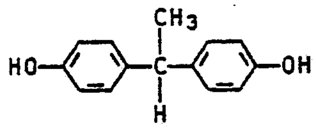
2,2-Di(4-hydroxyphenyl)ethan

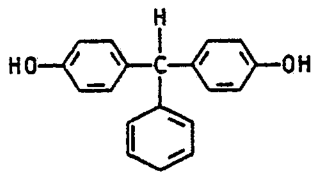
1-Phenyl-1,1-di-(4-hydroxyphenyl)methan

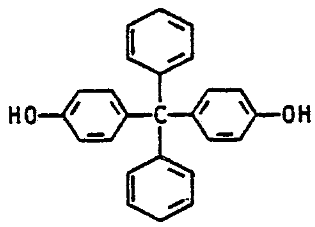
Diphenyl-di-(4-hydroxyphenyl)methan

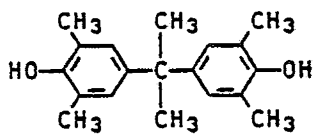
Tetramethylbisphenol A

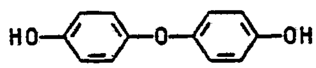
4,4'-Dihydroxydiphenylether

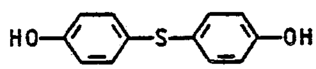
4,4'-Dihydroxydiphenylsulfid

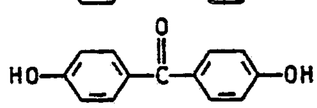
4,4'-Dihydroxybenzophenon

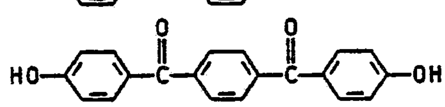
1,4-Di-(4'-hydroxyphenylcarbonyl)benzol

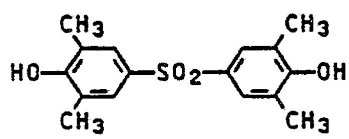
Tetramethylbisphenol S

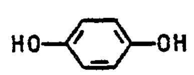
Hydrochinon

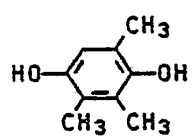
2,3,6-Trimethylhydrochinon

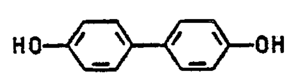
4,4'-Dihydroxydiphenyl

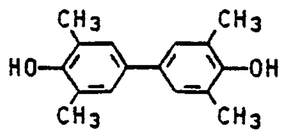

3,3',5,5'-Tetramethyl-4,4'-dihydroxydiphenyl

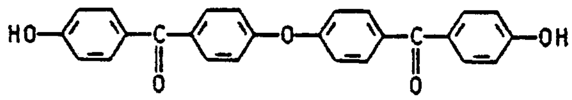

Dihydroxybenzophenonether

Die Anteile der Dihydroxyverbindungen $a_1$, $a_2$ und gegebenenfalls $a_3$, betragen
10 bis 90 mol.% a1
10 bis 90 mol.% $a_2$
0 bis 50 mol.% $a_3$, jeweils bezogen auf die Summe von $a_1$-$a_3$.
Bevorzugt werden Anteile von
30 bis 70 mol.% $a_1$
30 bis 70 mol.% $a_2$
0 bis 40 mol.% $a_3$.

Bei den Verbindungen $a_4$ und gegebenenfalls $a_5$, durch deren Umsetzung mit den Verbindungen $a_1$, $a_2$ und gegebenenfalls $a_3$ die erfindungsgemäße Komponente A erhältlich ist, handelt es sich um aromatische Dihalogenverbindungen. Verbindung $a_4$ ist 4,4'-Dichlor- bzw. 4,4'-Difluordiphenylsulfon bzw. deren $C_1$-$C_6$-alkylsubstituierte oder halogensubstituierte Derivate wie 3,3,5,5'-Tetramethyl-4,4'-dichlordiphenylsulfon bzw. die entsprechende Fluorverbindung. Die beiden Halogensubstituenten können gleich oder verschieden sein. v und w können 0, 1, 2, 3 oder 4, vorzugsweise 0, 1 oder 2 sein.

Die Verbindungen $a_5$ haben die allgemeine Formel

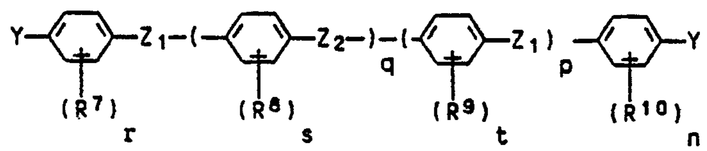

wobei
Y: Cl oder F

$Z_1$: 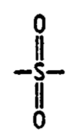 oder 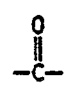

$Z_2$: —O—, —S—, 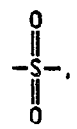, 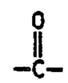 oder eine chemische Bindung darstellen.

$R^7$, $R^8$, $R^9$ und $R^{10}$ Wasserstoff, Cl oder F sind oder die gleiche Bedeutung wie $R^1$ und $R^2$ haben können,
q und p den Wert 0 oder 1 haben und
r, s, t und u eine ganze Zahl von 0 bis 4 sein können.

Bevorzugt ist $Z_2$ eine chemische Bindung,
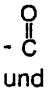 - oder -$SO_2$-
und $R^7$, $R^8$, $R^9$ und $R^{10}$ sind bevorzugt Wasserstoff, Methyl, Ethyl oder Cl oder F.
r, s, t und u können jeweils 0, 1, 2, 3 oder 4, vorzugsweise 0, 1 oder 2 sein.

Nachfolgend seien nur stellvertretend einige bevorzugte Dihalogenverbindungen $a_4$ bzw. $a_5$ aufgeführt.

dungen $a_4$ bzw. $a_5$ aufgeführt.

Name der Chlorverbindung

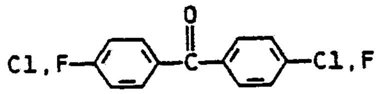
4,4'-Dichlorbenzophenon

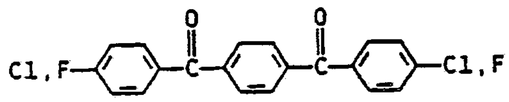
1,4-Di-(4'-chlorphenylcarbonyl)benzol

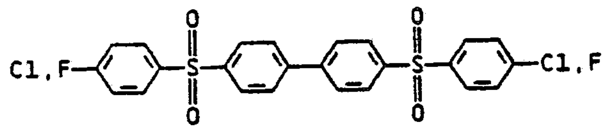
1,10-Di-(4'-chlorphenylsulfon)-diphenyl

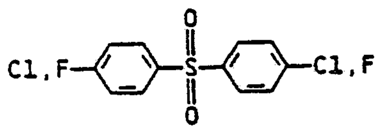
4,4'-Dichlordiphenylsulfon

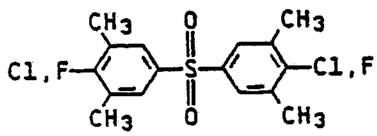
3,3',5,5'-Tetramethyl-4,4'-dichlordiphenylsulfon

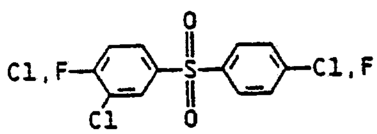
3-Chlor-4,4'-dichlordiphenylsulfon

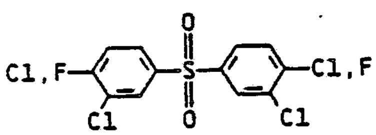
3,3'-4,4'-Tetrachlordiphenylsulfon

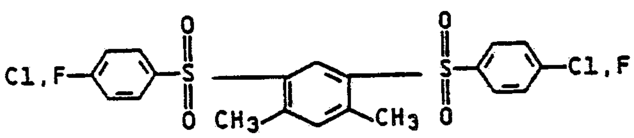
1,3-Dimethyl-4,6-di-(4-chlorphenylsulfon)benzol

Der Anteil der Dihalogenverbindung $a_4$ beträgt 1 bis 100 mol.%, bezogen auf die Summe von $a_4$ und $a_5$, vorzugsweise 20 bis 100 mol.%, besonders bevorzugt 50 bis 100 mol.%.

Als weitere Komponente B bzw. C enthalten die erfindungsgemäßen Polymermischungen Polyarylethersulfone mit wiederkehrenden Einheiten

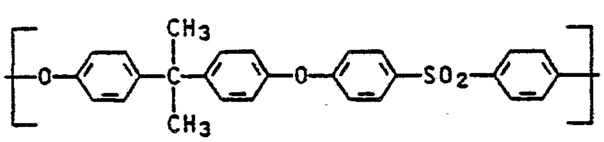
(Komponente B)

und/oder 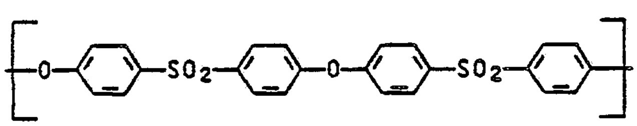 (Komponente C)

Diese sind erhältlich durch Polykondensation von Bisphenol A bzw. Bisphenol S mit 4,4'-Dichlordiphenylsulfon. Bis zu 20 mol% der Dihydroxyverbindungen (Bisphenol A bzw. Bisphenol S) oder der Dihalogenverbindungen können durch andere Monomere ersetzt werden. Auf diese Weise erhält man je nach Herstellungsverfahren statistische oder blockartige Copolymerisate, die mindestens 80 mol.% Einheiten

enthalten, die sich von Bisphenol A bzw. Bisphenol S und 4,4'-Dichlordiphenylsulfon ableiten.

Als andere Monomere eignen sich prinzipiell die bereits beschriebenen Dihydroxyverbindungen $a_3$ bzw. Dihalogenverbindungen $a_4$ bzw. $a_5$ (wobei bei $a_4$ 4,4'-Dichlordiphenylsulfon auszunehmen ist). Es ist auch möglich, in Polyarylethersulfonen des Typs B bis zu 20 mol% Einheiten einzubauen, die sich von Bisphenol S als Dihydroxyverbindung ableiten und entsprechend im Fall der Polysarylsulfone C Einheiten, die sich von Bisphenol A als Dihydroxykomponente ableiten.

Neben den wesentlichen Komponenten A, B und/oder C können die erfindungsgemäßen Polymermischungen außerdem verstärkend wirkende Füllstoffe, gegegebenenfalls transparente Pigmente und andere Hilfs- und Zusatzstoffe enthalten.

Als verstärkend wirkende Füllstoffe seien beispielsweise Asbest, Kohle und vorzugsweise Glasfasern genannt, wobei die Glasfasern z.B. in Form von Glasgeweben, -matten, -vliesen und/oder vorzugsweise Glasseidenrovings oder geschnittener Glasseide aus alkaliarmen E-Glasen mit einem Durchmesser von 5 bis 200 µm, vorzugsweise 8 bis 15 µm, zur Anwendung gelangen, die nach ihrer Einarbeitung eine mittlere Länge von 0,05 bis 1 mm, vorzugsweise 0,1 bis 0,5 mm, aufweisen. Die mit Glasseidenrovings oder geschnittener Glasseide verstärkten Formmassen enthalten zwischen 10 und 60 Gew.%, vorzugsweise 20 bis 50 Gew.%, des Verstärkungsmittels, bezogen auf das Gesamtgewicht, während die imprägnierten Glasgewebe, -matten und/oder -vliese zwischen 10 und 80 Gew.%, vorzugsweise zwischen 30 und 60 Gew.% Copolykondensate, bezogen auf das Gesamtgewicht, enthalten. Als Pigmente eignen sich beispielsweise Titandioxid, Cadmium-, Zinksulfid, Bariumsulfat und Ruß. Als andere Zusatz- und Hilfsstoffe kommen beispielsweise in Betracht Farbstoffe, Schmiermittel, wie z.B. Graphit oder Molybdändisulfid, Schleifmittel, wie z.B. Carborund, Lichtstabilisatoren und Hydrolyseschutzmittel. Die Pigmente, Zusatz- und Hilfsstoffe werden üblicherweise in Mengen von 0,01 bis 3 Gew.%, bezogen auf das Gewicht an Polykondensaten, eingesetzt.

Auch Wollastonit, Calciumcarbonat, Glaskugeln, Quarzmehl, Si- und Bornitrid oder Mischungen dieser Füllstoffe sind verwendbar.

Die Herstellung der Komponenten A, B und C kann im Prinzip nach den für die Herstellung von Polysulfonen oder Polyethersulfonen bekannten Verfahren erfolgen, die in der Literatur beschrieben sind. Im folgenden wird stellvertretend ein bevorzugtes Verfahren beschrieben.

Abhängig davon, ob bei der Herstellung der Komponente A alle Monomeren gleichzeitig oder in zeitlichem Abstand eingesetzt werden, lassen sich Produkte mit statistischer Verteilung der wiederkehrenden Einheiten oder aber Produkte mit blockweisem Aufbau erhalten. Prinzipiell können in den erfindungsgemäßen Polymermischungen beide Produkttypen eingesetzt werden.

Die aromatischen Dihydroxyverbindungen $a_1$, $a_2$, und gegebenenfalls $a_3$ können in einem molaren Verhältnis von 0,8:1 bis 1,2:1, vorzugsweise 0,9:1 bis 1,1:1, insbesondere 0,98:1 bis 1,02:1 mit aromatischen Dihalogenverbindungen, und besonders bevorzugt mit einer äquimolaren Menge an aromatischen Dihalogenverbindungen in Gegenwart von 1,0 bis 2,0 mol, vorzugsweise 1,05 bis 1,5 mol eines wasserfreien Alkalicarbonats, insbesondere $K_2CO_3$, in einem aprotischen, polaren Lösungsmittel umgesetzt werden.

Als geeignete aprotische polare Lösungsmittel werden N-substituierte Säureamide und Lactame bevorzugt. Nur beispielsweise seien N,N-Dimethylformamid, N,N-Dimethylacetamid oder N-Methylpyrrolidon genannt.

Falls gewünscht kann dem Lösungsmittel ein Azeotropbildner zur Entfernung des Reaktionswassers zugegeben werden. Derartige Verbindungen sind in der Literatur beschrieben. Vorteilhaft läßt sich jedoch auch in Abwesenheit eines Azeotropbildners arbeiten.

Die Menge der Monomeren, bezogen auf die Gesamtmenge des Lösungsmittels beträgt im allgemeinen 20 bis 80, vorzugsweise 30 bis 70, insbesondere 40 bis 60 Gew.%.

Bei Temperaturen im Bereich von 100 bis 200, vorzugsweise 130 bis 180°C kann der Hauptanteil des gebildeten Reaktionswassers entfernt werden. Dies kann z.B. allein thermisch, durch Zugabe eines Azeotropbildners oder bevorzugt durch Anlegen eines Unterdrucks erfolgen.

Anschließend kann die Kondensation bei Temperaturen im Bereich von 180 bis 220°C bis zur Erreichung der gewünschten Molmasse bzw. des gewünschten Kondensationsgrads weitergeführt werden.

Die Reaktionszeit beträgt in der Regel insgesamt von 5 bis 20, vorzugsweise von 7 bis 15 h und ist natürlich von den Reaktionsbedingungen (Temperatur und Druck) sowie von der gewünschten Molmasse des Produkts abhängig.

Im Anschluß an die Polykondensation können zur Stabilisierung freie Phenolat-Endgruppen mit einem Aryl- oder Alkylierungsmittel, wie z.B. Methylchlorid, umgesetzt werden. Dies erfolgt vorzugsweise bei Temperaturen von 50 bis 200, vorzugsweise 50 bis 150°C.

Das bei der Polykondensation anfallende suspendierte Alkalihalogenid kann mit einer geeigneten Trenneinrichtung, beispielsweise einem Klärfilter oder einer Zentrifuge abgetrennt werden.

Die Isolierung der Polymeren aus der Lösung kann durch Verdampfen des Lösungsmittels oder Ausfällung in einem geeigneten Nicht-Lösungsmittel erfolgen.

Die Polymerkomponenten A, B und C, insbesondere nach dem vorstehend beschriebenen Verfahren hergestellte Produkte, haben im allgemeinen eine reduzierte Viskosität in 1 Gew.% Phenol/o-Dichlorbenzol (1:1)-Lösung bei 25° C, von 0,35 bis 3,0, vorzugsweise 0,45 bis 1,0, insbesondere 0,45 bis 0,85.

Die erfindungsgemäßen Polymermischungen zeichnen sich durch ihre ausgewogenen Eigenschaften aus. Bei einer hohen Wärmeformbeständigkeit und einer guten Spannungsrißbeständigkeit zeichnen sie sich durch eine geringe Wasseraufnahme aus und sind sehr gut verarbeitbar. Darüber hinaus zeigen sie ein gutes Brandverhalten und eine geringe Rauchgasentwicklung.

Bemerkenswert ist auch auch, daß über weite Mischungsverhältnisse die Transparenz der aus den Formmassen hergestellten Produkte erhalten bleibt.

Die erfindungsgemäßen Polymermischungen können zur Herstellung von Formkörpern, Folien und Fasern verwendet werden. Insbesondere eignen sie sich wegen ihrer guten Eigenschaften zur Herstellung von Leiterplatten und elektrische Steckverbindungen.

Beispiele

Herstellung der Copolymeren A

A/1 In einem 300 l Behälter mit Rührer und $N_2$-Anschluß wurden unter Stickstoffatmosphäre 86 kg N-Methylpyrrolidon, 11,41 kg Bisphenol A (50 mol), 12,51 kg 4,4′ Dihydroxydiphenylsulfon (50 mol) und 28,72 kg 4,4′-Dichlordiphenylsulfon gelöst und mit 15,2 kg wasserfreiem Kaliumcarbonat (150 mol) versetzt.
Die Reaktionsmischung wurde bei einem Druck von 300 mbar (30 kPa) unter ständigem Abdestillieren des Reaktionswassers und N-Methylpyrrolidon zunächst 1 h auf 180° C erhitzt und 3 h bei dieser Temperatur belassen. Danach wurde 6 h bei 190° C weiter umgesetzt.
Durch Zusatz von Methylchlorid bei einer Temperatur von 150° C und zweistündiger Reaktion unter Druck (0,5 bar) wurde die Polykondensation abgebrochen.
Nach Zugabe von 125 kg N-Methylpyrrolidon wurden die anorganischen Bestandteile abfiltriert und das Polymere durch Fällung in Methanol als Feststoff isoliert. Nach Trocknung bei 100° C im Vakuum wurde das Polymer in Granulat konfektioniert.

A/2 Es wurde wie bei A/1 gearbeitet, nur unter Verwendung von 25 mol.% Bisphenol A und 75 mol.% 4,4′-Dihydroxydiphenylsulfon.

A/3 Es wurde wie bei A/1 gearbeitet, jedoch eine Mischung aus 75 mol.% Bisphenol A und 25 mol.% 4,4′-Dihdyroxydiphenylsulfon (DHDPS) eingesetzt.

A/4 Es wurde wie bei A/1 gearbeitet, nur eine Mischung aus 40 mol.% Bisphenol A und 60 mol.% 4,4′-Dihydroxydiphenylsulfon (DHDPS) eingesetzt.

A/5 Copolymerisat wie A/3, nur mit blockweisem Aufbau (Gewichtsmittelwert des Molekulargewichts des Blocks mit Einheiten, die sich von Bisphenol A ableiten = 15 000)

Komponente B

B/1 Polyarylethersulfon mit wiederkehrenden Einheiten der Formel

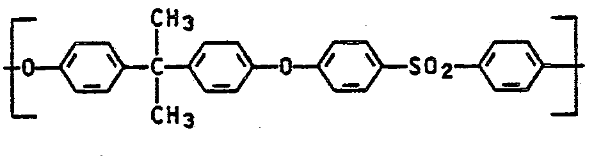

(Gewichtsmittelwert des Molekulargewichts = 48000)

B/2 Polyarylethersulfon mit wiederkehrenden Einheiten

(90 mol.%) 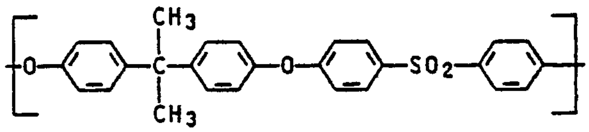 und

(10 mol.%) 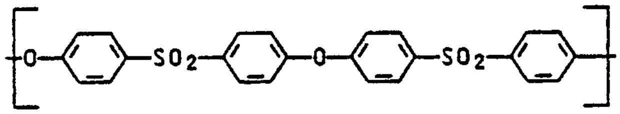

(Gewichtsmittelwert des Molekulargewichts $M_w$ = 42000)

B/3 Polyarylethersulfon mit weiderkehrenden Einheiten

(80 mol.%) 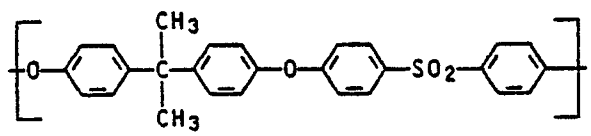

(20 mol.%) 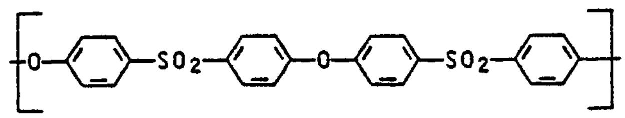

(Gewichtsmittelwert des Molekulargewichts = 40000)

Die Komponenten B/1, B/2 und B/3 wurden nach dem für die Komponente A/1 beschriebenen Verfahren hergestellt, wobei die Monomeren in den entsprechenden Anteilen eingesetzt wurden.

Komponente C

C/1 Polyarylethersulfon mit wiederkehrenden Einheiten der allgemeinen Formel

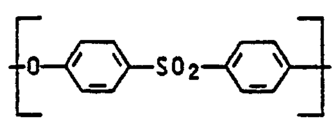

(Gewichtsmittelwert des Molekulargewichts = 40000)

C/2 Polyarylethersulfon aus wiederkehrenden Einheiten

90 mol.% 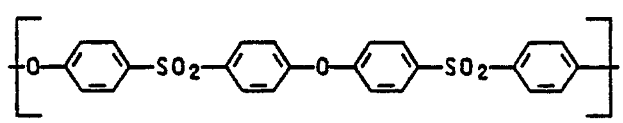

10 mol.% 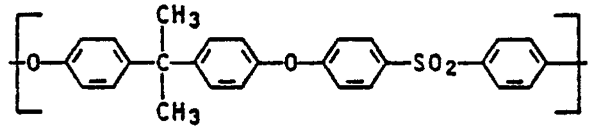 und

(Gewichtsmittelwert des Molekulargewichts = 42000)

C/3 Polyarylethersulfon aus wiederkehrenden Einheiten

80 mol.% 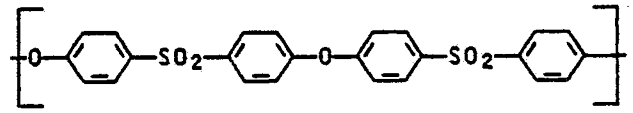

20 mol.%) 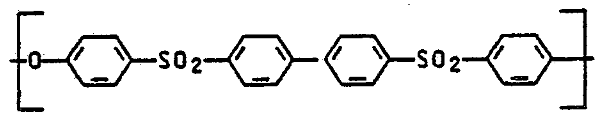

(Gewichtsmittelwert des Molekulargewichts = 41000)

Die Komponenten C/1 bis C/3 wurden nach dem für die Komponente A/1 beschriebenen Verfahren unter Verwendung der jeweils erforderlichen Monomeren hergestellt.

Zur Herstellung der erfindungsgemäßen Polymermischungen wurden die Komponenten auf einem Zweischneckenextruder gemischt, extrudiert, granuliert und getrocknet.

Zur Beurteilung der Transparenz wurden Rundscheiben von 2 mm Dicke im Spritzguß hergestellt.

Die Zusammensetzung der Mischungen und die Maßergebnisse sind den Tabellen 1 - 3 zu entnehmen.

Tabelle 1 (alle Mengenangaben in Gew.%)

| Bsp.-Nr. | Komponente A | Komponente B | Komponente C | Transparenz 2) | Tg 1) °C |
|---|---|---|---|---|---|
| 1 | 90 A/1 | 10 B/1 | - | + | |
| 2 | 75 A/1 | 25 B/1 | - | + | |
| 3 | 50 A/1 | 50 B/1 | - | + | |
| 4 | 25 A/1 | 75 B/1 | - | + | 190/208 |
| 5V | - | 100 B/1 | - | + | 187 |
| 6 | 90 A/1 | - | 10 C/1 | + | |
| 7 | 75 A/1 | - | 25 C/1 | + | |
| 8 | 50 A/1 | - | 50 C/1 | + | |
| 9 | 25 A/1 | - | 75 C/1 | + | 211/222 |
| 10V | - | - | 100 C/1 | + | 227 |
| 11 | 5 A/1 | 47,5 B/1 | 47,5 C/1 | - | 189/211/225 |
| 12 | 10 A/1 | 45 B/1 | 45 C/1 | - | 189/211/223 |
| 13 | 33 A/1 | 33 B/1 | 34 C/1 | (+) | 189/209/222 |
| 14 | 50 A/1 | 25 B/1 | 25 C/1 | (+) | 190/209/224 |
| 15 | 70 A/1 | 15 B/1 | 15 C/1 | + | 189/210/225 |
| 16V | - | 50 B/1 | 50 C/1 | - | 188/224 |

V = Vergleichsversuch

1) = Glasübergangstemperatur

2) + = transparent

(+) = leicht trüb

- = opak

Tabelle 2 (alle Mengenangaben in Gew.%)

| Bsp.-Nr. | Komponente A | Komponente B | Komponente C | Transparenz[2] | Tg[1] °C |
|---|---|---|---|---|---|
| 17 | 90 A/2 | 10 B/1 | - | + | |
| 18 | 50 A/2 | 50 B/1 | - | (+) | 191/218 |
| 19 | 10 A/2 | 90 B/1 | - | + | |
| 20 | 90 A/2 | - | 10 C/1 | + | |
| 21 | 50 A/2 | - | 50 C/1 | + | |
| 22 | 10 A/2 | - | 90 C/1 | + | |
| 23 | 40 A/2 | 10 B/1 | 50 C/1 | + | |
| 24 | 90 A/3 | 10 B/1 | - | + | |
| 25 | 50 A/3 | 50 B/1 | - | + | 195 |
| 26 | 10 A/3 | 90 B/1 | - | + | |
| 27 | 90 A/3 | - | 10 C/1 | + | |
| 28 | 50 A/3 | - | 50 C/1 | (+) | 197/227 |
| 29 | 10 A/3 | - | 90 C/1 | + | |
| 30 | 40 A/3 | 50 B/1 | 10 C/1 | + | |
| 31 | 50 A/4 | 50 B/1 | - | + | 191/213 |
| 32 | 50 A/4 | - | 50 C/1 | + | 222 |
| 33 | 50 A/5 | 50 B/1 | - | + | |
| 34 | 50 A/5 | - | 50 C/1 | + | |
| 35 | 50 A/5 | 25 B/1 | 25 C/1 | + | |

[1], [2] wie in Tabelle 1

Tabelle 3 (alle Mengenangaben in Gew.%)

| Bsp.-Nr. | Komponente A | Komponente B | Komponente C | Transparenz[2] |
|---|---|---|---|---|
| 36 | 50 A/1 | 50 B/2 | | + |
| 37 | 50 A/1 | - | 50 C/2 | + |
| 38 | 50 A/1 | 50 B/3 | - | (+) |
| 39 | 50 A/1 | - | 50 C/3 | (+) |
| 40 | 50 A/1 | 25 B/2 | 25 C/2 | + |

[2] s. Tabelle 1

Die Ergebnisse in den Tabellen zeigen, daß über weite Bereiche transparente Formmassen erhalten werden, während Mischungen aus Polyarylethersulfonen B/1 und C/1 über weite Mischungsbereiche nicht transparent sind.

Gegenüber Polyarylethersulfonen B allein ergibt sich eine verbesserte Wärmeformbeständigkeit, gegenüber Polyarylethersulfonen C allein eine verbesserte Wasseraufnahme.

## Ansprüche

1. Polymermischung auf der Basis von Polyarylethersulfonen, enthaltend als wesentliche Komponenten

A) 5 - 95 Gew.% eines Polyarylethersulfons, erhältlich durch Polykondensation einer Mischung aus

$a_1$) 10 bis 90 mol.%, bezogen auf die Summe von A)-C),

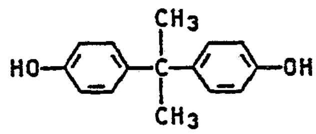

$a_2$) 10 bis 90 mol.%, bezogen auf die Summe von A)-C),

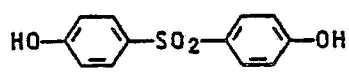

$a_3$) 0 bis 50 mol.%, bezogen auf die Summe von A)-C),

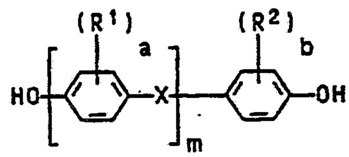

wobei X eine chemische Bindung oder einen Substituenten

—S— , —O— , 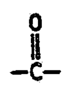 , 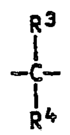 ($R^3$=$R^4$=$CH_3$ nur wenn mindestens a oder b ≠ 0)

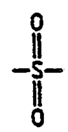 (nur wenn a oder b ≠ 0)

$R^1$ und $R^2$ Alkylgruppen mit 1 bis 6 C-Atomen oder $C_1$-$C_6$-Alkoxygruppen, $R^3$ und $R^4$ Wasserstoff, Alkylgruppen mit 1 bis 6 C-Atomen, Arylgruppen oder halogensubstituierte Alkylgruppen mit 1 bis 4 C-Atomen darstellen und m den Wert 0 oder 1 und n und p den Wert 0, 1, 2, 3 oder 4 haben,

mit

$a_4$) 1 bis 100 mol.%, bezogen auf die Summe von D) und E)

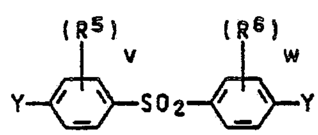

wobei $R^5$ und $R^6$ Wasserstoff sind oder die gleiche Bedeutung wie $R^1$ und $R^2$ haben, Y Cl oder F ist und v und w jeweils den Wert 0, 1, 2, 3 oder 4 haben, und

$a_5$) 0 bis 99 mol.%, bezogen auf die Summe von D) und E)

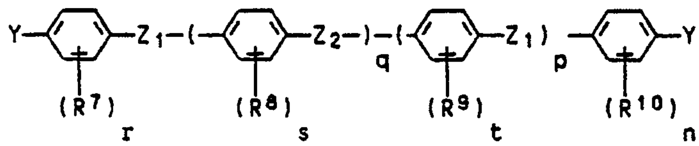

wobei Y: Cl oder F

$Z_1$: 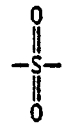 oder 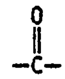

$Z_2$: –O–, –S–, 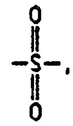, 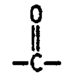 oder eine chemische Bindung darstellen

$R^7$, $R^8$, $R^9$ und $R^{10}$, Wasserstoff, Cl oder F sind oder die gleiche Bedeutung wie $R^1$ und $R^2$ haben können,

q und p den Wert 0 oder 1 haben und

r, s, t und u eine ganze Zahl von 0 bis 4 sein können,

B) 0 - 95 Gew.% eines Polyarylethersulfons mit wiederkehrenden Einheiten der allgemeinen Formel

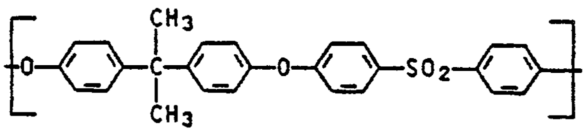

und/oder

C) 0 - 95 Gew.% eines Polyarylethersulfons mit wiederkehrenden Einheiten der allgemeinen Formel

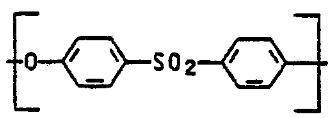

wobei der Gesamtanteil der Komponenten B + C) mindestens 5 Gew.%, bezogen auf A + B + C) beträgt.

2. Polymermischung nach Anspruch 1, gekennzeichnet durch folgende Gehalte

A) 15 - 95 Gew.%

B) 0 - 85 Gew.%

C) 0 - 85 Gew.%

und mit einem Gesamtanteil B + C) von mindestns 5 Gew.%, bezogen auf A + B + C).

3. Verwendung der Polymermischungen gemäß Anspruch 1 zur Herstellung von Leiterplatten und elektrischen Steckverbindungen.

4. Formkörper, erhältlich aus Polymermischungen gemäß Anspruch 1 als wesentlichen Komponenten.